# EUROPEAN PATENT APPLICATION

(11) **EP 0 660 522 A2**
(43) Date of publication of application: **28.06.1995**
(21) Application number: 94119732.9
(22) Date of filing: 14.12.1994
(51) Int. Cl.: H03K 19/003

(54) **Semiconductor integrated circuit device**

(30) Priority: 21.12.1993 JP 320718/93
(71) Applicant: KABUSHIKI KAISHA TOSHIBA, Kawasaki-shi, Kanagawa-ken 210 (JP)
(72) Inventor: Namekawa, Toshimasa, c/o Intellectual Prop. Div., Minato-ku, Tokyo 105 (JP); Ohsawa, Takashi, c/o Intellectual Prop. Div., Minato-ku, Tokyo 105 (JP)
(74) Representative: Lehn, Werner, Dipl.-Ing.

(57) **Abstract**

In a semiconductor integrated circuit device of the present invention, a plurality of connection terminals (12-1 to 12-4) are connected to corresponding external signals. A plurality of buffers (6-1 to 6-4) are electrically connected relative to the corresponding connection terminals. A changeover switching circuit (8) is connected between the plurality of buffers and a corresponding number of internal signal lines (10-1 to 10-4) so that an electric signal delivered from one of the buffer is switchingly transmitted to an internal signal line or lines.

## Description

The present invention relates to a semiconductor integrated circuit device having a plurality of operation bodes on one chip and, in particular, to a semiconductor integrated circuit device which, even if the number of internal signal lines electrically connected to a connection terminal varies by a selected operation mode, involves no prominent variation in the electrical characteristic of the connection terminal.

Conventionally, in the manufacturing of a semiconductor integrated circuit device having a delicately different operation mode in spite of having a given basic function, such a different operation mode has been achieved, by the replacement of a connection layer alone, during the manufacturing process of that semiconductor integrated circuit device.

In order to achieve more operation modes, it is necessary to achieve more connection layouts. Even if the connection layer alone is replaced for that purpose, no desirable result can be obtained from the standpoint of the manufacturing cost. Therefore, it has been necessary to switch the operation modes by corresponding lead connection states in the semiconductor device (hereinafter referred to as the mounting of a semiconductor device).

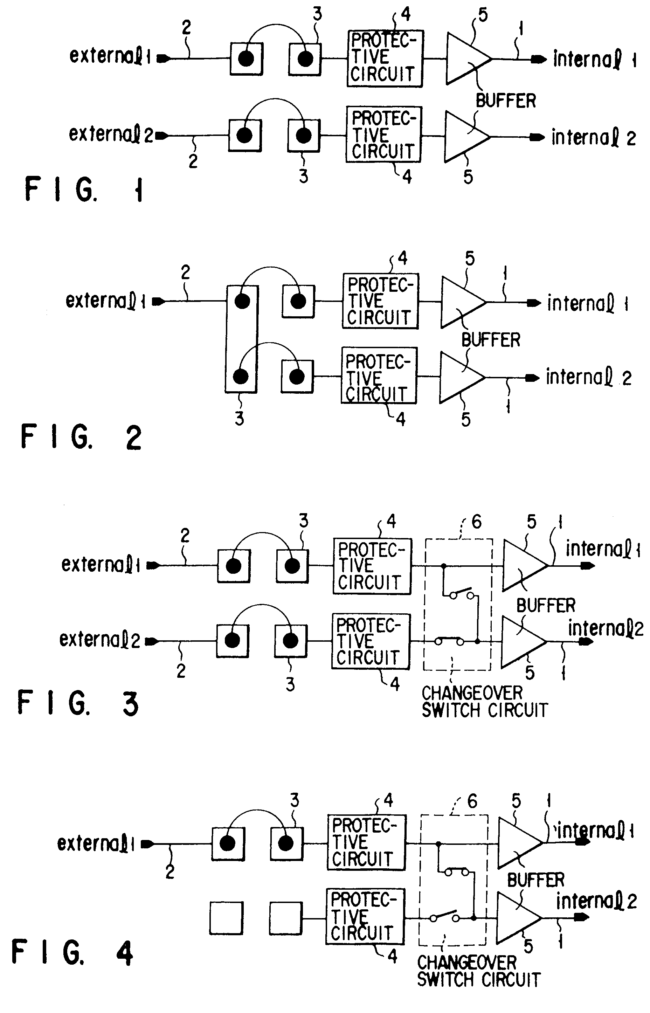

In the case where the operation mode of the semiconductor device is determined by the state of bonding or mounting in the semiconductor device, the state of interconnection is simply determined as shown in FIGS. 1 and 2. As shown in FIG. 1, for example, a terminal 3, protective circuit 4 and buffer 5 are connected in that order from each of external signal lines 2 toward a corresponding one of internal signal lines 1.

In the case where one external signal line 2 of a semiconductor device is connected to an internal signal line 1 through the brunching of a terminal 3, a plurality of protective circuits 4 corresponding in number to internal signal lines 2 are connected relative to the external signal line, as shown in FIG. 2, so that the terminal of interest involves a different electrical characteristic than an ordinary terminal, such as the increase in input impedance.

In order to prevent such a different electrical characteristic, a switch 6 may be placed after the protective circuit 4 but before the buffer 5 so as to switch the operation mode. This form of a circuit is as shown in FIGS. 3 and 4.

In these cases, however, a plurality of buffers 5 are connected to one terminal 3, thus revealing a variation in electrical characteristic. It may be considered that, since the external signal line connected to a changeover switch 6 allows a signal which comes from an outside of the semiconductor device to pass through, a signal may be input outside a voltage range in which the changeover switch 6 operates normally.

In the case where, in FIG. 3 for example, the changeover switch 6 is constructed of a transfer gate comprised of an N channel MOSFET, if a negative potential signal is input to the external 1 of the external signal line, the transfer gate to be turned OFF is turned ON, thus exerting an influence over the buffer 5 on the internal 2 side of the external signal line and hence producing an operation error.

There is also a risk that different signals will both emerge from the two buffers 5 when an intermediate voltage signal near to a buffer threshold level is input to the external 1. This is because a voltage drop occurs across an internal resistance in the changeover switch 6 to cause an input signal potential which is input to the two buffers 5 to vary in a delicate way.

In the prior art, if the number of internal signal lines electrically connected to the connection terminal varies in accordance with the operation mode, the electric characteristic of the connection terminal varies such as an increase in input impedance. This causes the risk of the semiconductor integrated circuit producing an operation error.

It is accordingly the object of the present invention to provide a semiconductor integrated circuit device which, even if the number of internal signal lines electrically connected to the connection terminal varies by a selected operation mode, involves no prominent variation in the electrical characteristic of the connection terminal.

According to one aspect of the present invention there is provided a semiconductor integrated circuit device comprising:
a first pad;
a second pad;
a third pad;
a fourth pad; and
input means having first, second, third, and fourth input terminals and first, second, third, and fourth output terminals respectively;
wherein a first mode is so set that the first input terminal is associated with the first output terminal,
the second input terminal is associated with the second output terminal,
the third input terminal is associated with the third output terminal, and
the fourth input terminal is associated with the fourth output terminal;
a second mode is so set that the first input terminal is associated with the first and second output terminals, and
the third input terminal is associated with the third and fourth output terminals; and
a third mode is so set that the first input terminal is associated with the first, second, third and fourth output terminals;
wherein a first input impedance at the first input terminal, a second input impedance at the second input terminal, a third input impedance at the third input terminal and a fourth input impedance at the fourth input terminal are essentially the same.

According to another aspect of the present invention there is provided a semiconductor integrated circuit device comprising:
a first pad;
a second pad;
input means having first and second input terminals and first and second output terminals;
wherein a first mode is so set that the first input terminal is associated with the first output terminal, and
the second input terminal is associated with the second output terminal; and
a second mode is so set that the first input terminal is associated with the first and second output terminals;
wherein a first input impedance at the first input terminal and a second input impedance at the second input terminal are essentially the same.

According to another aspect of the present invention there is provided a semiconductor integrated circuit device comprising:
a first pad;
a second pad;
a first output terminal;
a second output terminal;
a first buffer having a first input node and a first output node, the first input node being connected to the first pad, and the first output node being connected to the first output terminal;
a second buffer having a second input node and a second output node, the second input node being connected to the second pad, and the second output node being connected to the second output terminal;
a first switch means connected between the first output node and the second output terminal; and
a second switch means connected between the second output node and the second output terminal wherein the first and second switches are controlled complementarily.

According to another aspect of the present invention there is provided a semiconductor integrated circuit device comprising:
a plurality of connection terminals connected to external signal line means;
a plurality of buffer means provided for respective terminals and electrically connected to the connection terminals;
a plurality of internal signal lines; and
switching means, connected between the plurality of buffer means and the plurality of internal signal lines, for enabling an electric signal which is output from one of the buffer means to be transferred, in accordance with an operation mode, to either one or more internal signal lines.

According to another aspect of the present invention there is provided a semiconductor integrated circuit device comprising:
a plurality of connection terminals connected to external signal lines;
buffer means provided for the connection terminals and electrically connected to these connection terminals;
switching means for allowing an electric signal which is output from one of the buffer means to be switchingly transferred as an internal signal to data buffers corresponding to a dynamic RAM in accordance with an operation mode;
mode select circuit means, connected to the buffer means and switching means, for delivering an operation mode signal corresponding to the operation mode to the buffer means and switching means;
a dynamic RAM output control circuit means, comprised of data buffer means and I/O PAD, for delivering output signals corresponding to the operation mode coming from the buffer means transferred from the switching means; and
a dynamic RAM, connected to the output control circuit, for having its output controlled by the output control circuit means, the dynamic RAM being operated in accordance with an operation mode selected from a plurality of operation modes.

In the arrangement as set out above, the semiconductor integrated circuit device of the present invention includes a switching transfer means provided at a subsequent stage of the buffer means arranged, in a one-to-one correspondence, for each connection terminal whereby, even if the number of internal signal lines electrically connected to the connection terminals is varied depending upon an operation mode, no prominent variation in the electrical characteristic of the connection terminals occur. Further, since the switching transfer means is located at the subsequent stage of the buffer means, there is less risk of the switching transfer means producing an operation error.

This invention can be more fully understood from the following detailed description when taken in conjunction with the accompanying drawings, in which:
FIG. 1 shows a state of connection of internal and external signal lines in a conventional device which is made in accordance with an operation mode;
FIG. 2 shows a state of connection of conventional internal and external signal lines corresponding to a different operation mode from that of FIG. 1;
FIG. 3 is a view showing one form of changeover switch before buffers in the connection shown in FIG. 1;
FIG. 4 is a view showing another form of changeover switch before buffers in the connection in FIG. 2;
FIG. 5A shows a major section of a dynamic RAM according to one embodiment of the present invention, a state of connection of external and internal signal lines when a 4CAS mode for controlling four internal signals is selected and one form of changeover switching circuit connected after buffers;
FIG. 5B shows a second embodiment of the present invention, a state of connection of external and internal signal lines when a 2CAS mode for controlling four internal signals is selected and another form of changeover switching circuit connected after buffers;
FIG. 5C shows another embodiment of the present invention, a state of connection of external and internal signal lines when a 1CAS mode for controlling four internal signals is selected and a changeover switching circuit connected after buffers;
FIG. 6 is a circuit arrangement showing a dynamic RAM using the form of connection in FIGS. 5A, 5B and 5C;
FIG. 7 is a circuit arrangement showing a protective circuit in FIGS. 5A, 5B and 5C;
FIG. 8 is a table showing a relation of input and output signals in the protective circuits in FIG. 7;
FIG. 9 is a view showing a circuit arrangement of the buffer 6 in FIGS. 5A, 5B and 5C;
FIG. 10 is a view showing a relation of input and output signals of the buffers 6 in FIG. 9;
FIG. 11 is a circuit diagram showing the changeover switching circuit in FIGS. 5A, 5B and 5C;
FIG. 12A shows a dynamic RAM of another embodiment of the present invention, illustrating a state of connection of external and internal signal lines when a 2WE mode is selected and a changeover switching circuit connected after buffer means;
FIG. 12B shows a dynamic RAM according to another embodiment of the present invention, illustrating a state of connection of external and internal signal lines when a 1WE mode is selected and a changeover switching circuit connected after buffers;
FIG. 13 is a circuit arrangement showing buffers 6-1 and 6-2 as illustrated in FIGS. 12A and 12B; and
FIG. 14 is a view showing a changeover switching circuit 8 in FIGS. 12A and 12B.

One embodiment of the present invention will be explained below by, for example, a pattern correction method using an ion beam.

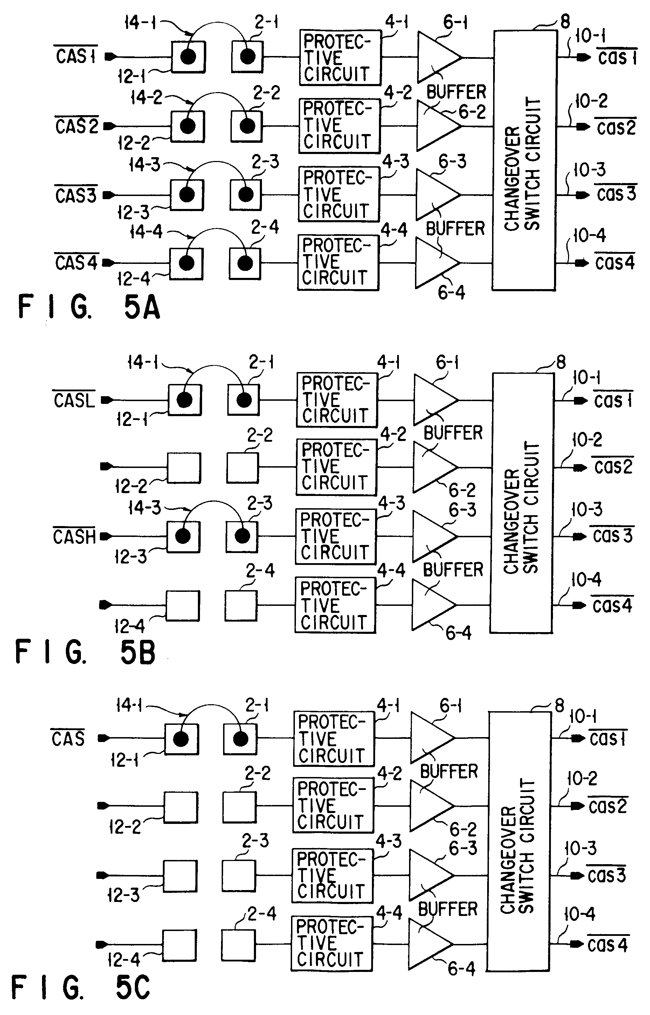

As shown in FIG. 5A, CAS (column address strobe) pads 2-1 to 2-4 are provided in a semiconductor chip to supply a CAS signal. A plurality of leads are provided around a chip with their one-end sides brought out to a semiconductor device's package to allow the CAS signal to be taken out of the lead. Bonding wires are connected to the other-end sides of the leads.

In FIG. 5A, the other-end sides of the leads are indicated by reference numerals 12-1 to 12-4 and bonding wires are indicated by reference numerals 14-1 to 14-4.

The CAS pads 2-1 to 2-4 are connected by connection lines to protective circuits 4-1 to 4-4 which, in turn, are connected to the inputs of CAS buffers 6-1 to 6-4, respectively. The outputs of the respective CAS buffers 6-1 to 6-4 are connected to the input of a changeover switching circuit 8. The output of the changeover switching circuit 8 is connected to a plurality of internal signal lines 10-1 to 10-4.

The changeover switching circuit 8 effects switching such that the destination of one buffer output delivered from one CAS buffer is transmitted as a signal to one internal signal line or lines in accordance with an operation mode.

FIG. 5B shows the state of connection of external and internal signal lines when a 2CAS mode for controlling four internal signals is selected by two external signals as shown in another embodiment of the present invention, that is, shows one form of connection made by the changeover switching circuit after buffering.

FIG. 5C shows the state of connection of external and internal signal lines when an 1CAS mode for controlling four internal signals is selected by one external signal as shown in the embodiment as set out above, that is, shows another form of connection made by the changeover switching after buffering.

The changeover switching circuit 8 delivers internal signals Bcas1 to Bcas4, noting that "B" in Bcas1 to Bcas4 indicates a bar showing an inverted replica of these signals. These internal signal lines 10-1 to 10-4 allow the internal signals Bcas1 to Bcas4 to be transmitted.

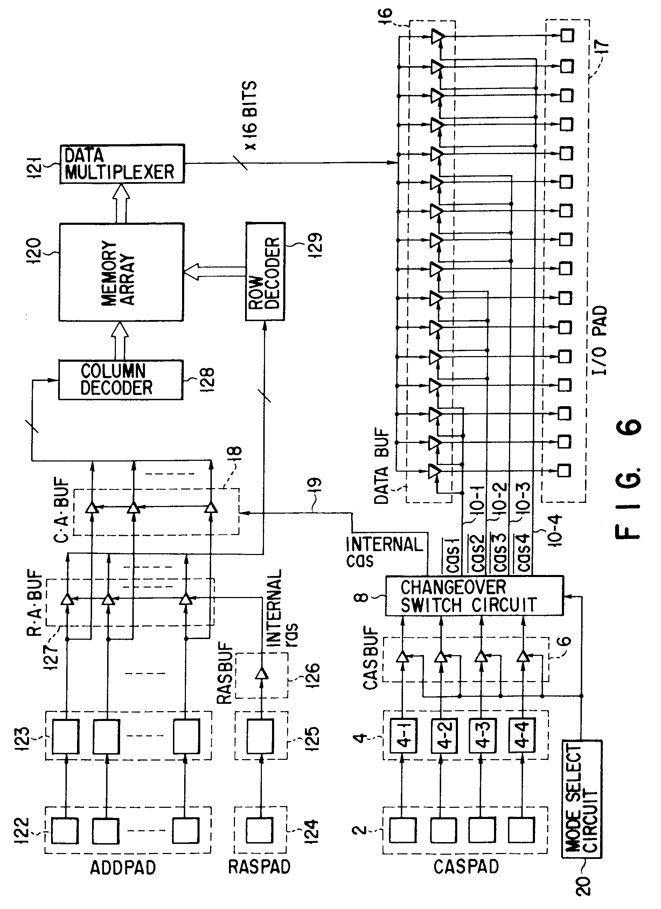

FIG. 6 shows a schematic arrangement of a DRAM.

DRAM as shown is of a × 16 bit configuration having 16 input/output pads.

A data output from a memory array 120 is determined by receiving respective outputs of a column decoder 128 and row decoder 129 and the output is supplied to a data buffer group 16 via a data multiplexer 121.

The outputs of ADDPAD 122 are input via a protective circuit 123 to an R·A·BUF127 and to C·A·BUF18. R·A·BUF127 has its outputs controlled by receiving an output from a RASPAD 124 via a protective circuit 125 and RASBUF126 and drives row decoder 129. C·A·BUF18 has its output controlled by receiving an internal cas signal 19 from the changeover switch 8 and drives the column decoder 18.

The above-mentioned arrangement is substantially the same as a system in a present-day DRAM.

The internal signals Bcas1 to Bcas4 are input to the data buffer group 16 and the input and output of data to and from I/O PAD 17 are controlled in accordance with an operation mode.

The changeover switching circuit 8 delivers an internal cas 19 as another signal. The internal cas is input to a column address buffer group 18 to control the take-in timing of an address signal.

As shown in FIGS. 5A to 5C, with DRAM according to the first embodiment, three operation modes are required for BCAS.

One of the operation modes corresponds to a 4CAS mode for allowing the internal signals Bcas1, Bcas2, Bcas3 and Bcas4 to be controlled by four external signals, BCAS1, BCAS2, BCAS3 and BCAS4, as shown in FIG. 5A.

At the 4CAS mode, the CAS pads 2-1 to 2-4 are connected to the other-end 12-1 to 12-4 sides of the leads by the wires 14-1 to 14-4, respectively. At a 4CAS mode, 16 outputs are divided into four equal units and data outputs are controlled, four at a time, by the four external signals.

Another operation mode corresponds to a 2CAS mode for allowing the internal signals Bcas1, Bcas2, Bcas3 and Bcas4 to be controlled by two external signals, BCASL and BCAH, as shown in FIG. 5B.

At the 2CAS mode, the CAS pads 2-1 and 2-3 are connected to the other-end 12-1 and 12-3 sides by the wires 14-1 and 14-3. At the 2CAS mode, the 16 outputs from the I/O PAD 17 as shown in FIG. 6 are divided into 8 equal units, delivered as such, and controlled 8 bits at a time.

Still another mode corresponds to a 1CAS mode for allowing one external signal, BCAS, as shown in FIG. 5C to control the internal signals Bcas1, Bcas2, Bcas3 and Bcas4.

At the 1CAS mode, the CAS pad 2-1 is connected to the other-end 12-1 side by the wire 14-1. For the 1CAS mode, the 16 outputs cannot be divided and 16 data outputs are controlled at a time by one external signal.

As shown in FIG. 6, a mode select circuit 20 is provided in the chip so as to generate an operation mode signal corresponding to an operation mode. The mode select circuit 20 delivers operation mode signals to CAS buffers 6-1 to 6-4 and changeover switching circuit 8.

The protective circuit 4, CAS buffer 6 and changeover switching circuit 8 so configured as shown in FIG. 6 will be explained in more detail.

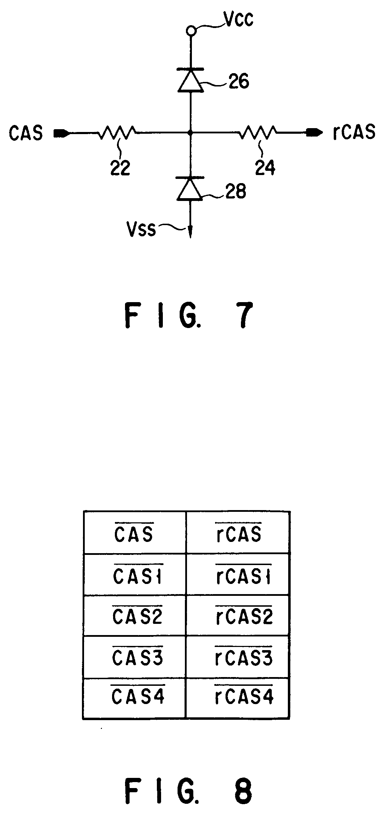

FIG. 7 shows a circuit arrangement showing the circuit configuration of the protective circuit 4. In the circuit arrangement shown, a series circuit of first and second resistors 22 and 24 is connected between the input terminal and the output terminal of the protective circuit 4. The anode of a first protective diode 26 and cathode of a second protective diode 28 are connected to a common point between the first resistor 22 and the second resistor 24. The cathode of the first protective diode 26 is connected to a high potential power supply Vcc in the protective circuit and the anode of the second protective diode 28 is connected to a low potential power supply Vss in the protective circuit.

The protective circuit 4 so configured is provided as the protective circuits 4-1 to 4-4 in FIGS. 5A to 5C. FIG. 8 shows a relation of the input signal BCAS to the output signal BrCAS.

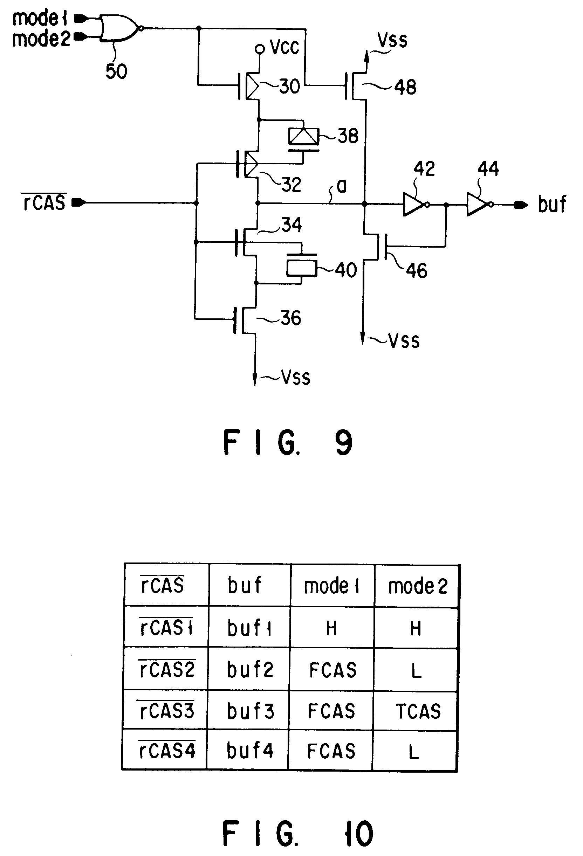

FIG. 9 is a circuit diagram showing a circuit arrangement of a CAS buffer 6.

Between the power supply Vcc and the power supply Vss a series circuit of a PMOS 30, PMOS 32, NMOS 34 and NMOS 36 is connected as shown in FIG. 9. The gates of the three MOSFETs (PMOS 32, NMOS 34 and NMOS 36) on the power supply Vss side are connected to the input terminal of the CAS buffer 6.

A capacitor 38 constituted by a PMOS is connected between the input terminal and a common connection point of the PMOSs 30 and 32 and a capacitor 40 constituted by an NMOS is connected between the input terminal and a common point of NMOS 34 and PMOS 36.

These capacitors 38 and 40 are so provided that the output signal level is not varied simply by a near-noise level.

A series circuit of inverters 42 and 44 is connected between a common connection point a of PMOS 32 and NMOS 34 and the output terminal of the CAS buffer 6. An NMOS 46 is connected between the connection point a and the power supply Vss. The gate of NMOS 46 is connected to a common connection point between the output of the inverter 42 and the input of the inverter 44.

NMOS 46 is turned ON when the output of the inverter 42 becomes a "H" level and, by doing so, the input of the inverter 42 drops to a "L" level so that the operation of the CAS buffer 6 is stabilized.

An NMOS 48 is connected between the common point a and the power supply Vss. The gate of NMOS 48 is connected to the gate of PMOS 30 and to the output of a NOR gate 50. NOR 50 has two inputs, input sections mode 1 and mode 2, supplied with an operation mode signal corresponding to an operation mode.

The CAS buffer 6 so configured is provided as the CAS buffers 6-1 to 6-4 in FIGS. 5A to 5C.

FIG. 10 shows a relation of an input signal BrCAS to an output signal buf of the CAS buffer 6 and relation of the operation modes to the operation mode signals input to the input sections mode1 and mode2.

Let it be assumed that, at the 4CAS mode, the signal levels of FCAS (abbreviation of Four CAS) and TCAS (abbreviation of Two CAS) as shown in FIG. 10 denote "H" and "L", respectively. At this time, since, for CAS buffers 6-1 to 6-4, at least one input logic level becomes a "H" level, the output of NOR 50 becomes a "L" level in either case.

In all the buffers 6-1 to 6-4, PMOS 30 is turned ON and NMOS 48 is cut off. As a result, for the buffers 6-1 to 6-4, a power supply Vcc is fed to an inverter section comprised of NMOSs 34, 36 and PMOS 32 and all the CAS buffers 6-1 to 6-4 are all activated.

At the 2CAS mode, it is assumed that the signal levels of FCAS and TCAS as shown in FIG. 10 are represented by "L" and "H", respectively. At that time, for the two CAS buffers 6-1 and 6-3, at least one input logical level of NOR50 becomes a "H" level and their outputs become both "L" levels.

The outputs of NORs 50 of the other buffers 6-2 and 6-4 become both "L" levels when at least one input logical level of NORs 50 becomes a "H" level. For the buffers 6-1 and 6-3, therefore, PMOS 30 is turned ON and NMOS 48 is cut off.

As a result, a power supply Vcc is fed to the inverter section only in the buffers 6-1 and 6-3 in which case only the buffers 6-1 and 6-3 are activated to buffer a signal BrCASL to a signal buf 1 and a signal BrCASH to a signal buf 3.

At this time, for the other buffers 6-2 and 6-4, PMOS 30 is cut off and NMOS 48 is turned ON so that no power supply is fed to the inverter section. ON the other hand, a "L" level signal is supplied by NMOS 48 to the input of the inverter 42. In consequence, even if the CAS pads 12-2 and 12-4 stay in an electrically floated state, the logical levels of signals buf 2 and buf 4 delivered from the buffers 6-2 and 6-4 are fixed to a "L" state at all times.

Let it be assumed that, at a 1CAS mode, the signal levels of FCAS and TCAS as shown in FIG. 10 are placed in a "L" state. At this time, at least one input logical level of NOR 50 in the CAS buffer 6-1 only becomes a "H" level and the outputs of NORs 50 of the other buffers 6-2 to 6-4 become both at the "L" level. In the buffer 6-1 only, PMOS 30 is turned ON and NMOS 48 is cut off.

As a result, a signal BrCAS is buffered to a signal buf 1.

Since in either of the other buffers 6-2 to 6-4, PMOS 30 is cut off and NMOS 48 is turned ON, the logical levels of those signals buf 2 to buf 4 are fixed to a "L" level at all times.

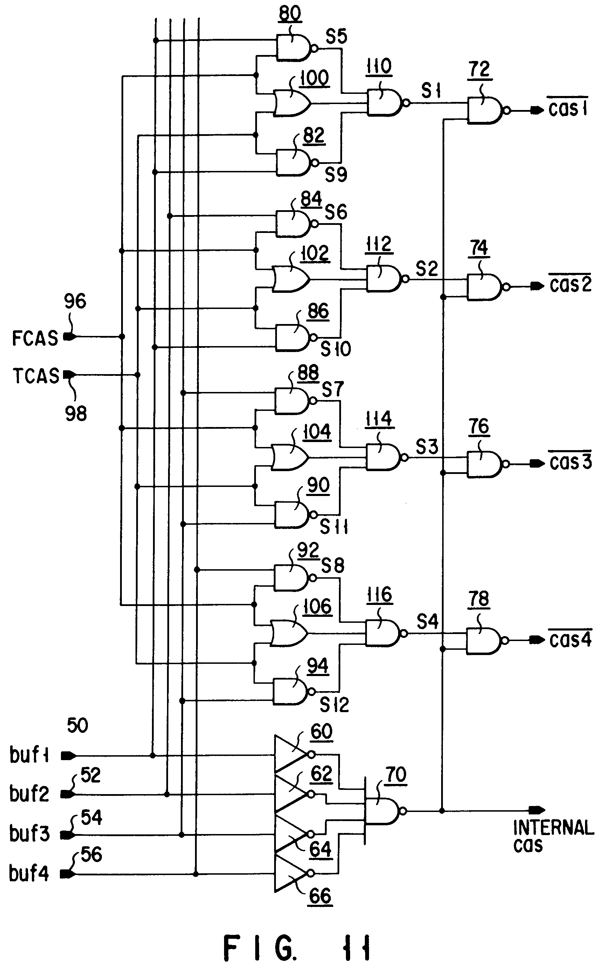

FIG. 11 is a circuit arrangement showing the changeover switching circuit 8.

As shown in FIG. 11, four input terminals 50, 52, 54 and 56 are connected to four inputs of a NAND 70. The output of NAND 70 is used as an internal signal (internal cas) and connected to one input of each of two-input NANDs 72, 74, 76 and 78 at an output stage via inverters 60 to 66. Of these four input terminals, the input terminal 50 is connected to one input of each of two-input NAND 80, 82 and 86. The input terminal 52 is connected to one input terminal of the two-input NAND 84. The input terminal 54 is connected to one input terminal of each of two input NANDs 88, 90 and 94. The input terminal 56 is connected to one input of a two-input NAND 92.

In the changeover switching circuit 8, operation mode signal input terminals 96 and 98 are provided as an input section of an operation mode signal.

The mode signals FCAS and TCAS as explained in connection with FIG. 10 are input to the signal input terminals 96 and 98, respectively.

Of the two terminals, the terminal 96 is connected to the other input terminal of each of the two-input NANDs 80, 84, 88 and 92 and to one input of each of two-input logical gates (OR) 100, 102, 104 and 106.

The signal input terminal 98 is connected to the other input terminal of each of the two-input NANDs 82, 86, 90 and 94 and to the other input of each of the two-input ORs 100, 102, 104 and 106.

The outputs of the NANDs 80, 82 and OR 100 are connected to the inputs of a three-input NAND 110, the output of which is connected to the other input of the NAND 72 at the output stage.

The outputs of NANDs 84, 86 and OR 102 are connected to the inputs of a three-input NAND 112, the output of which is connected to the other input of NAND 74 at the output stage.

The outputs of NANDs 88, 90 and OR 104 are connected to the inputs of a three-input NAND 114, the output of which is connected to the other input of the output stage NAND 76.

The outputs of NANDs 92, 94 and OR 106 are connected to the inputs of a three-input NAND 116, the output of which is connected to the other input of the output stage NAND 78.

The operation of the changeover switching circuit 8 as shown in FIG. 11 will be explained below.

A basic operation will first be explained below in connection with those input signals buf 1 to buf 4.

If any one of the input signals buf 1 to buf 4 is at a logical "H" level, a "H" signal is supplied to the one-input sides of the output stage NANDs 72, 74, 76 and 78. The output logical levels of NANDs 72, 74, 76, 78 are determined depending upon the logical level of the signal supplied to their other input sides. If, for example, an output signal S1 of the three-input NAND 110 is at the "H" level, Bcas1 is at a "L" level and, if an output signal S1 is at the "L" level, Bcas1 is at a "H" level. A similar operation as set out above is performed at the other NANDs 74, 76 and 78.

If, on the other hand, any of the input signals buf 1 to buf 4 is at a logical "L" level, an "L" level signal is supplied to the one-input side of the output-stage NANDs 72, 74, 76 and 78. As a result, Bcas1 to Bcas4 becomes a logical "H" level at all times irrespective of the logical levels of the output signals S1 to S4.

An operation according to the operation mode will be explained below.

First, when a mode signal CAS is at a "H" level and a mode signal TCAS at a "L" level (4CAS mode), the one-input sides of NANDs 80, 84, 88 and 92 are at a logical "H" level and hence the output logical levels S5 to S8 of NANDs 80, 84, 88 and 92 are determined by the other-input side logical level.

If, for example, the input signal buf 1 is at a "H" level, the other-end side input of NAND 80 becomes a "H" level and the output S5 of NAND 80 becomes a "L" level. When, on the other hand, the input signal buf 1 is at an input "L" level, the output S5 of NAND 80 becomes a "H" level. A similar operation as set out above is also conducted at the other NANDs 84, 88 and 92.

Since the one-input sides of NANDs 82, 86, 90 and 94 become a logical "L" level, the outputs S9 to S12 become a "H" level at all times irrespective of their other-input side logical level.

The one-end sides of OR gates 100, 102, 104 and 106 become a "H" level and their outputs become a "H" level at all times.

At the 4CAS mode, the outputs S1 to S4 of NANDs 110, 112, 114 and 116 are determined in accordance with the logical levels of the outputs S5 to S8 of NANDs 80, 84, 88 and 92.

When the mode signal FCAS is at the "L" level and mode signal TCAS at the "H" level (2CAS mode), the one-input sides of NANDs 82, 86, 90 and 94 become a logical "H" level and the logical levels S9 to S12 of the outputs of NANDs 82, 86, 90, 94 are determined by the logical levels S9 to S12 of their other-input sides.

For example, if the input signal buf 1 is at a "H" level, the other-input side of NAND 82 becomes a logical "H" level and the output S9 of NAND 82 becomes a "L" level and, if, on the other hand, the input signal buf 1 is at a "L" level, the output S9 of NAND 82 becomes a "H" level. A similar operation as set out above is performed at the other NANDs 86, 90 and 94.

Since the one-input sides of NANDs 80, 84, 88 and 92 become a logical "L" level, their outputs S5 to S8 become a "H" level irrespective of their other-input sides.

Further, the one-input sides of OR gates 100, 102, 104 and 106 become a logical "H" level and their outputs become a "H" level at all times.

At the 2CAS mode, the outputs S1 to S4 of NAND 110, 112, 114 and 116 are determined in accordance with the logical levels of the outputs S9 to S12 of NANDs 82, 86, 90 and 94.

Finally, when the mode signals FCAS and TCAS are both at a "L" level, the one-input sides of NANDs 80, 82, 84, 86, 88, 90, 92 and 94 become a logical "L" signal. The outputs of NANDs 80, 82, 84, 86, 88, 90, 92 and 94 become a logical "H" level irrespective of the logical levels of their other-input sides.

Further, any of the mode signals FCAS and TCAS is at a "L" level, both input sides of each of OR gates 100, 102, 104 and 106 become a "L" level. As a result, the outputs of these OR gates become a "L" level.

That is, at the 1CAS mode, the outputs of OR gates 100, 102, 104 and 106 become a "L" level at all times and the output signals S1 to S4 become a logical "H" level. As a result, the logical levels Bcas1 to Bcas4 are determined by the logical level of the output of the input NAND 70.

A dynamic type RAM according to a second embodiment of the present invention will be explained below.

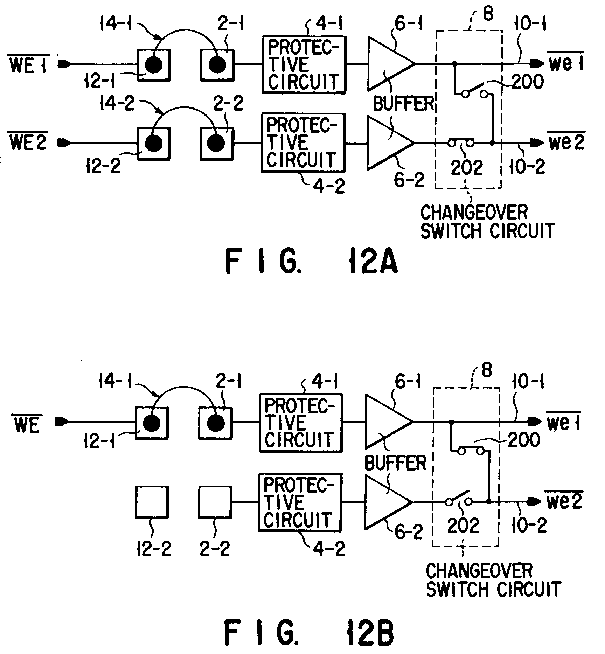

FIGS. 12A and 12B, each, are an arrangement showing a major part of a dynamic type RAM of the present invention.

The second embodiment is principally different from the first embodiment in that write enable (WE) signals are used in place of the CAS signals, that, as the circuit arrangement of the changeover switching circuit 8, use is made of simple switches 200 and 202 in place of the logic circuit and that, as the operation modes, two types are used in place of three. In FIGS. 12A and 12B, the same reference numerals are employed to designate parts or elements corresponding to those shown in FIGS. 5A to 5C to 11 and any further explanation is limited to those different parts only.

As shown in FIGS. 12A and 12B, with DRAM, two operation modes are sometimes required for BWE.

At one operation mode, internal signals Bwe1 and Bwe2 are controlled by two external signals, BWE1 and BWE2 as shown in FIG. 12A. Hence the 2WE mode.

At the 2WE mode a switch 200 is connected between the output of a buffer 6-1 and an internal signal line 10-2 to provide a series circuit. The switch 200 is shown cut-off. A switch 202 is connected in series with an internal signal line 10-2 and shown in an ON state.

At another operation mode, two internal signals Bwe1 and Bwe2 are controlled by one external signal BWE as shown in FIG. 12B. Hence a 1WE mode. At the 1WE mode, the switch 200 connected between the output of the buffer 6-1 and the internal signal line 10-2 is conducted and the switch 202 connected between the output of the buffer 6-2 and the internal signal line 10-2 is cut off.

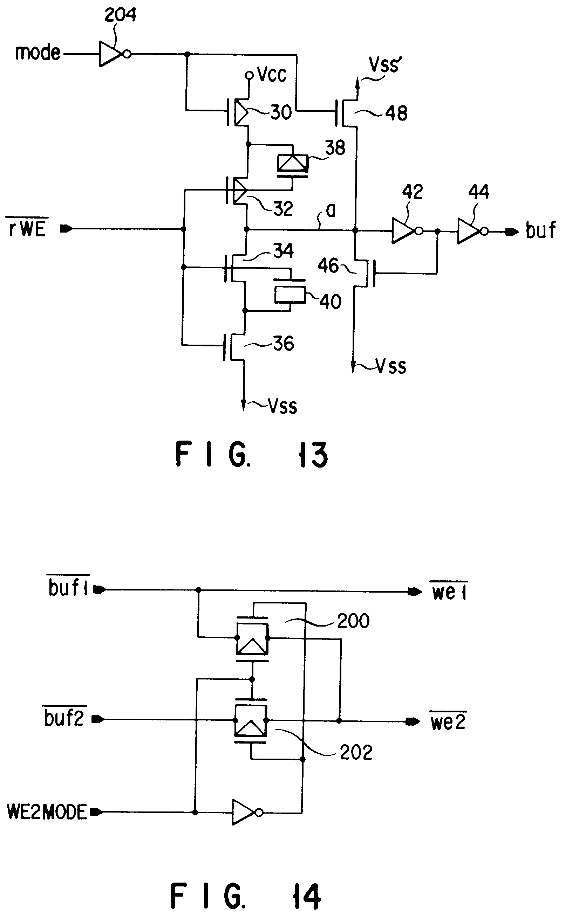

FIG. 13 is a circuit diagram showing the WE buffer 6-1 as shown in FIGS. 12A and 12B.

As shown in FIG. 13, the gate of a NMOS 48 is connected to the gate of a PMOS 30 and to the output of an inverter 204. The input of the inverter 204 serves as an input section mode supplied with an operation mode signal corresponding to the operation mode.

At a 2WE mode, a "H" level signal is supplied to the input section mode and, in any of the buffers 6-1 and 6-2, PMOS 30 is turned ON and NMOS 48 is cut off.

At the 2WE mode, a "H" level signal is supplied to the input section mode in any of the buffers 6-1 and 6-2. In both the buffers 6-1 and 6-2, PMOS 30 is turned ON and NMOS 48 is cut off.

At the 1WE mode, a "L" level signal is supplied to the input section mode of the buffer 6-1 and a "H" level signal is supplied to the input section mode of the buffer 6-2. In the buffer 6-1, therefore, PMOS 30 is turned ON and NMOS 48 is cut off. In the buffer 6-2, PMOS 30 is cut off and NMOS 48 is turned ON. With a pad 12-2 in an electrically floated state, an electrical signal buf 2 output from the buffer 6-2 is fixed to a "L" level.

FIG. 14 is a circuit diagram of a changeover switching circuit 8.

As shown in FIG. 14, switches 200 and 202 are, each, comprised of a CMOS type transfer gate. At a 2WE mode, the operation mode signal WE2MODE becomes a "H" level and the switch 202 is turned ON while, on the other hand, the switch 200 is cut off. At the 1WE mode, the operation mode signal WE2MODE becomes a "L" level and the switch 202 is cut off while the switch 200 is turned ON.

According to the device of the respective embodiment, a protective circuit and buffer are provided for each pad. Even if, with the changeover switch provided at a subsequent stage of the buffer above, the number of those signal lines electrically connected to the pad is varied depending upon the operation mode involved, no prominent variation is produced in the electrical characteristic of the pad, such as the input impedance and logical threshold level.

Further, the buffer has an input section of the operation mode signal and a switch controlled by the operation mode signal. This switch fixes the output of the buffer to its logical level irrespective of whether or not the input signal is input to the buffer. Even if, therefore, the pad is placed in an electrically floated state, the buffer output is fixed to its logical level and it is advantageously possible to alleviate the risk of, for example, the changeover switching circuit involving an operation error.

If the changeover switch is provided at the subsequent stage of the buffer, a signal adequately amplified at the buffer can be used for the input of the changeover switching circuit and, as in the first embodiment, the changeover switching circuit can be constructed as a logical circuit. When the changeover switching circuit is so constructed, it is easy to obtain a uniform transmission rate of signals involved.

With the changeover switching circuit constructed as a logic circuit, if, on respective signal transmission paths taken in accordance with the operation modes, their logical gate circuits are made equal in stage number, a uniform transmission rate can be obtained at the respective signal transmission paths, thus ensuring the advantage that the operation mode, even if being varied, causes no variation in the transmission rate of the changeover switching circuit. Considering, for example, the transmission path from the input terminal 50 to the output-side NAND 72 in the first embodiment of the present invention, there are a transmission path via a two-stage logical gate circuit including NAND 80 (or 82) to NAND 110 and a transmission path via a two-stage logical gate circuit including an inverter 60 to NAND 70. In these transmission paths, the number of stages of these logical gate circuits are equal, that is 2.

## Claims

1. A semiconductor integrated circuit device comprising:
a first pad;
a second pad;
a third pad;
a fourth pad; and
input means having first, second, third, and fourth input terminals and first, second, third, and fourth output terminals respectively;
wherein a first mode is so set that said first input terminal is associated with said first output terminal,
said second input terminal is associated with said second output terminal,
said third input terminal is associated with said third output terminal, and
said fourth input terminal is associated with said fourth output terminal;
a second mode is so set that said first input terminal is associated with said first and second output terminals; and
said third input terminal is associated with said third and fourth output terminals; and
a third mode is so set that said first input terminal is associated with said first, second, third and fourth output terminals;
wherein a first input impedance at said first input terminal, a second input impedance at said second input terminal, a third input impedance at said third input terminal and a fourth input impedance at said fourth input terminal are essentially the same.

2. A semiconductor integrated circuit device according to claim 1, characterized by further comprising:
a fifth pad;
a sixth pad;
a seventh pad; and
a eighth pad;
wherein in said first mode,
said fifth pad is connected via a bonding wire with said first input terminal,
said sixth pad is connected via a bonding wire with said second input terminal,
said seventh pad is connected via a bonding wire with said third input terminal,
said eighth pad is connected via a bonding wire with said fourth input terminal;
in said second mode,
said fifth pad is connected via a bonding wire with said first input terminal,
said seventh pad is connected via a bonding wire with said third input terminal,
and in said third mode,
said fifth pad is connected via a bonding wire with said first input terminal.

3. A semiconductor integrated circuit device according to claim 1, characterized in that said input means further includes first, second, third, and fourth buffers and a switch means connected to said first, second, third, and fourth buffers and for selectively connecting output terminals of said first, second, third, and fourth buffers to said output terminals in accordance with said first, second, and third modes.

4. A semiconductor integrated circuit device according to claim 3, characterized in that each of said first, second, third, and fourth buffers includes a first inverter having an input terminal in which buffer input is inputted; a second inverter connected to an output terminal of said first inverter and for producing an output as a buffer output; and means connected to a node between said first and second inverters and for fixing a potential of said node in accordance with an input mode signal even if an input of said first inverter is prevented.

5. A semiconductor integrated circuit device according to claim 3, characterized by further comprising:
protective circuit means inserted between said first, second, third and fourth input terminal and corresponding first, second, third and fourth buffers.

6. A semiconductor integrated circuit device according to claim 5, characterized in that
said protective circuit means comprises first, second, third and fourth protective circuits and said first protective circuit being connected between said first input terminal and said first buffer,
said second protective circuit being connected between said second input terminal and said second buffer,
said third protective circuit being connected between said third input terminal and said third buffer, and
said fourth protective circuit being connected between said fourth input terminal and said fourth buffer.

7. A semiconductor integrated circuit device according to claim 1, characterized by further comprising:
data output means including first, second, third and fourth buffer groups, each having a plurality of buffer circuits,
said first buffer group being connected to said first output terminal,
said second buffer group being connected to said second output terminal,
said third buffer group being connected to said third output terminal, and
said fourth buffer group being connected to said fourth output terminal.

8. A semiconductor integrated circuit device according to claim 1, characterized by further comprising:
data output means including first, second, third and fourth buffer groups, each having a plurality of buffer circuits,
said first buffer group being connected to said first output terminal,
said second buffer group being connected to said second output terminal,
said third buffer group being connected to said third output terminal, and
said fourth buffer group being connected to said fourth output terminal, and
a memory means connected to said data output means and including a memory array means for outputting an output data to said data output means.

9. A semiconductor integrated circuit device comprising:
a first pad;
a second pad;
input means having first and second input terminals and first and second output terminals;
wherein a first mode is so set that said first input terminal is associated with said first output terminal, and
said second input terminal is associated with said second output terminal; and
a second mode is so set that said first input terminal is associated with said first and second output terminals;
wherein a first input impedance at said first input terminal and a second input impedance at said second input terminal are essentially the same.

10. A semiconductor integrated circuit device according to claim 9, characterized by further comprising:
a third pad; and
a fourth pad;
wherein in said first mode,
said third pad is connected via a bonding wire with said first input terminal, and
said fourth pad is connected via a bonding wire with said second input terminal, and
in said second mode,
said third pad is connected via a bonding wire with said first input terminal, and
said fourth pad is connected via a bonding wire with said third input terminal.

11. A semiconductor integrated circuit device according to claim 9, characterized in that said input means further includes first and second buffers and a switch means connected to said first and second buffers and for selectively connecting output terminals of said first and second buffers to said output terminals in accordance with said first and second modes.

12. A semiconductor integrated circuit device according to claim 11, characterized by further comprising:
protective circuit means inserted between said first and second input terminals and corresponding first and second buffers.

13. A semiconductor integrated circuit device according to claim 12, characterized in that
said protective circuit means comprises first and second protective circuits and said first protective circuit being connected between said first input terminal and said first buffer, and
said second protective circuit being connected between said second input terminal and said second buffer.

14. A semiconductor integrated circuit device according to claim 9, characterized by further comprising:
data output means including first and second buffer groups, each having a plurality of buffer circuits,
said first buffer group being connected to said first output terminal and
said second buffer group being connected to said second output terminal.

15. A semiconductor integrated circuit device according to claim 9, characterized by further comprising:
data output means including first and second buffer groups, each having a plurality of buffer circuits,
said first buffer group being connected to said first output terminal,
said second buffer group being connected to said second output terminal; and
a memory means connected to said data output means and including a memory array means for outputting multiplex output data to said data output means.

16. A semiconductor integrated circuit device comprising:
a first pad;
a second pad;
a first output terminal;
a second output terminal;
a first buffer having a first input node and a first output node, said first input node being connected to said first pad, and said first output node being connected to said first output terminal;
a second buffer having a second input node and a second output node, said second input node being connected to said second pad, and said second output node being connected to said second output terminal;
a first switch means connected between said first output node and said second output terminal; and
a second switch means connected between said second output node and said second output terminal wherein said first and second switches are controlled complementarily.

17. A semiconductor integrated circuit device according to claim 16, characterized in that
said first switch means includes a first CMOS transfer gate and said second switch means includes a second CMOS transfer gate and
said first and second buffer means comprise an inverter respectively.

18. A semiconductor integrated circuit device according to claim 16, characterized in that
said first pad and said second pad are inputted with a write enable signal.

19. A semiconductor integrated circuit device according to claim 16, characterized by further comprising:
protective circuit means inserted between said first and second pads and corresponding first and second buffers.

20. A semiconductor integrated circuit device comprising:
a plurality of connection terminals connected to external signal line means;
a plurality of buffer means provided for respective terminals and electrically connected to the connection terminals;
a plurality of internal signal lines; and
switching means, connected between the plurality of buffer means and the plurality of internal signal lines, for enabling an electric signal which is output from one of the buffer means to be transferred, in accordance with an operation mode, to either one or more internal signal lines.

21. A semiconductor integrated circuit device according to claim 20, characterized in that said buffer means includes an input section for receiving an operation mode signal corresponding to the operation mode, the operation mode signal fixing a logical level of the electric signal output from the buffer means when the connection terminal is electrically floated.

22. A semiconductor integrated circuit device according to claim 20, characterized in that said switching means includes an input section for receiving the operation mode signal corresponding to the operation mode for enabling a transfer state, to the internal signal line, of one electric signal which is output from the buffer means to be transferred to one or more internal signal lines.

23. A semiconductor integrated circuit device according to claim 20, characterized in that said switching means is comprised of a logical circuit.

24. A semiconductor integrated circuit device according to claim 23, characterized in that the logical circuit comprises:
at least two first and second input terminals so provided as to correspond to the respective buffer means;
at least one third input terminal supplied with the operation mode signal;
first logical gate means having an input section electrically connected to the first and second input terminals;
second logical gate means having an input section electrically connected to one of the first and second input terminals and the third input terminal;
third logical gate means having the other of the first and second input terminals and input terminal;
fourth logical gate means having an input section electrically connected to an output of the first logical gate means and output of the second logical gate means and an output electrically connected to corresponding one of the internal signal lines; and
a fifth logical gate means having an input section electrically connected to an output section of the first logical gate means and output of the third logical gate means and an output electrically connected to the other internal signal line;
wherein the logical circuit allows a transfer path of electrical signals which are supplied to the first and second input terminals to be switched, in accordance with the operation mode, to either one of a first transfer path via the first logical gate means and fourth logical gate means and the first logical gate means and fifth logical gate means and a second transfer path via the second logical gate means and fourth logical gate means and the third logical gate means and said fifth logical gate means.

25. A semiconductor integrated circuit device according to claim 22, characterized in that the first, second and third logical gate means are made mutually equal in the number of their stages as viewed from the input section toward the output section.

26. A semiconductor integrated circuit device according to claim 22, characterized in that a CAS signal to a dynamic RAM is input to the at least first and second input terminals provided relative to the respective buffer means.

27. A semiconductor integrated circuit device comprising:
a plurality of connection terminals connected to external signal lines;
buffer means provided for the connection terminals and electrically connected to these connection terminals;
switching means for allowing an electric signal which is output from one of the buffer means to be switchingly transferred as an internal signal to data buffers corresponding to a dynamic RAM in accordance with an operation mode;
mode select circuit means, connected to the buffer means and switching means, for delivering an operation mode signal corresponding to the operation mode to the buffer means and switching means;
a dynamic RAM output control circuit means, comprised of data buffer means and I/O PAD, for delivering output signals corresponding to the operation mode coming from the buffer means transferred from the switching means; and
a dynamic RAM, connected to the output control circuit, for having its output controlled by the output control circuit means, the dynamic RAM being operated in accordance with an operation mode selected from a plurality of operation modes.

28. A dynamic RAM device according to claim 27, characterized in that is operated in accordance with an operation mode selected from the semiconductor integrated circuit device having a plurality of operation modes, wherein the buffer means includes an input section for receiving an operation mode signal corresponding to the operation mode, the operation mode signal fixing a logical level of an electric signal output from the buffer means when the connection terminal is electrically floated.

29. A dynamic RAM device according to claim 27, characterized in that the switching means includes an input section for receiving an operation mode signal corresponding to an operation mode, the operation mode signal allowing a transfer state, to the internal signal line, of one electric signal which is output from the buffer means to be switchingly transferred to one or more internal signal lines.

30. A dynamic RAM device according to claim 27, characterized in that the switching means is comprised of a logical circuit.

31. A dynamic RAM device according to claim 30, characterized in that the logical circuit comprises:
at least two first and second input terminals so provided as to correspond to the respective buffer means;
at least one third input terminal supplied with the operation mode signal;
first logical gate means having an input section electrically connected to the first and second input terminals;
second logical gate means having an input section electrically connected to one of the first and second input terminals and the third input terminal;
third logical gate means having the other of the first and second input terminals and input terminal;
fourth logical gate means having an input section electrically connected to an output of the first logical gate means and output of the second logical gate means and an output electrically connected to corresponding one of the internal signal lines; and
a fifth logical gate means having an input section electrically connected to an output section of the first logical gate means and output of the third logical gate means and an output electrically connected to the other internal signal line;
wherein the logical circuit allows a transfer path of electrical signals which are supplied to the first and second input terminals to be switched, in accordance with the operation mode, to either one of a first transfer path via the first logical gate means and fourth logical gate means and the first logical gate means and fifth logical gate means and a second transfer path via the second logical gate means and fourth logical gate means and the third logical gate means and said fifth logical gate means.
